# EUROPÄISCHE PATENTSCHRIFT

(11) **EP 2 931 932 B1**
(45) Veröffentlichungstag und Bekanntmachung des Hinweises auf die Patenterteilung: **28.10.2020**
(21) Anmeldenummer: 13799506.4
(22) Anmeldetag: 26.11.2013
(51) Int. Cl.: C23C 2/06, C23C 2/12, C23C 2/26, C23C 14/02, C23C 14/14, C23C 16/02, C23C 16/06, C23C 28/02, C23C 14/16, C25D 3/22

(54) **OBERFLÄCHENVEREDELTES STAHLBLECH UND VERFAHREN ZU DESSEN HERSTELLUNG**
SURFACE FINISHED STEEL SHEET AND METHOD OF ITS MANUFACTURE
TÔLE D'ACIER TRAITÉE EN SURFACE ET PROCÉDÉ DE SA FABRICATION

(30) Priorität: 11.12.2012 DE 102012112109
(43) Veröffentlichungstag der Anmeldung: 21.10.2015
(73) Patentinhaber: ThyssenKrupp Steel Europe AG, 47166 Duisburg (DE)
(72) Erfinder: BÖGER, Thorsten, 47906 Kempen (DE); KLAUKE, Peter, 58239 Schwerte (DE); SCHÜSSLER, Anastasia, 45473 Mühlheim an der Ruhr (DE)
(74) Vertreter: ThyssenKrupp Steel Europe AG
(86) Internationale Anmeldenummer: PCT/EP2013/074669
(87) Internationale Veröffentlichungsnummer: WO 2014/090561

(56) Entgegenhaltungen:
- WO-A1-03/053682
- WO-A1-2012/030726
- DE-A1-102006 047 060
- DE-A1-102011 008 787
- JP-A- 08 060 326

## Beschreibung

Die Erfindung betrifft ein oberflächenveredeltes Stahlblech gemäß Anspruch 1 aus Kohlenstoffstahl mit einer Beschichtung, die aus mindestens einer metallischen Korrosionsschutzschicht und mindestens einer weiteren, auf die metallische Korrosionsschutzschicht stoffschlüssig aufgebrachten Schicht aufgebaut ist. Des Weiteren betrifft die Erfindung ein Verfahren gemäß Anspruch 7 zum Herstellen eines oberflächenveredelten Stahlblechs, bei dem auf ein Flachprodukt aus Kohlenstoffstahl mindestens eine metallische Korrosionsschutzschicht und auf die mindestens eine metallische Korrosionsschutzschicht mindestens eine weitere Schicht stoffschlüssig aufgebracht werden.

Aufgrund schlechter Korrosionsbeständigkeit werden unbeschichtete Kohlenstoffstähle üblicherweise mit einer Verzinkung gegen Korrosion geschützt. Aus Gründen der Ästhetik wird anschließend eine oft mehrschichtige, farbgebende organische Lackbeschichtung aufgetragen, die die Korrosionsbeständigkeit weiter erhöht. Die zur Gewährleistung der Korrosionsschutz- und Lackhaftungswirkung in den Lacksystemen und Grundierungen enthaltenen chemischen Stoffe sind jedoch mitunter gesundheits- und umweltschädlich, da diese häufig Schwermetalle wie Nickel, Chrom6 und Chrom3 beinhalten.

Bei farbgebenden organischen Lackbeschichtungen besteht zudem das Problem, dass diese bei intensiver UV-Lichteinwirkung mehr oder weniger schnell ausbleichen.

Als Alternative zu verzinkten Stahlblechen aus Kohlenstoffstahl stehen zwar auch rostfreie Edelstahl- und Kupferbleche zur Verfügung, jedoch sind diese relativ teuer. Allgemein ist insbesondere Edelstahl aufgrund seiner metallischen Legierungselemente wie Chrom, Titan und Nickel ein relativ teures Material.

In der WO 2012/030726 A1 ist ein verzinktes Stahlblech aus Kohlenstoffstahl beschrieben, das ein rostfreies Edelstahlblech imitieren soll. Hierzu wird die Zinkschicht des Stahlblechs gepresst und texturiert, wobei die Textur eine Oberflächenrauhigkeit im Bereich von 0,127 bis 1,524 µm (= 5 bis 60 microinches) aufweist. Das verzinkte und texturierte Kohlenstoffstahlblech weist zudem eine organische Beschichtung auf, die einen zusätzlichen Korrosionsschutz darstellt und durch die das Erscheinungsbild des Blechs entsprechend seiner Endverwendung variiert werden kann. Die organische Beschichtung kann dabei aus einer transparenten Polyesterfolie bestehen, welche insbesondere eine Anti-Fingerabdruck-Funktion hat. Dieses verzinkte und texturierte Stahlblech ist jedoch hinsichtlich seiner ästhetischen Wirkung eher unbefriedigend.

DE 102006047060A1 und JP08060326A offenbaren Stahlbleche mit einer zweilagigen metallischen Beschichtung und WO03/053682A1 offenbart ein Substrat, bei dem eine Oberfläche mit dem Erscheinungsbild von Edelstahl mittels metallischer Beschichtung erzeugt wird.

Der vorliegenden Erfindung liegt die Aufgabe zugrunde, ein Stahlblech der eingangs genannten Art zu schaffen, das ohne farbgebende organische Lackbeschichtung auskommt, hinsichtlich seiner ästhetischen Wirkung einen hochwertigen Eindruck vermittelt und zudem eine sehr hohe UV-Beständigkeit aufweist.

Gelöst wird diese Aufgabe durch ein oberflächenveredeltes Stahlblech mit den Merkmalen des Anspruchs 1 sowie durch ein Verfahren zum Herstellen eines oberflächenveredelten Stahlblechs mit den Merkmalen des Anspruchs 7. Bevorzugte und vorteilhafte Ausgestaltungen des erfindungsgemäßen Stahlblechs bzw. des Verfahrens zu dessen Herstellung sind in den Unteransprüchen angegeben.

Die Vorteile der vorliegenden Erfindung liegen in der Farbgebung bzw. ästhetischen Wirkung, die durch die weitere metallische Schicht erzeugt wird. Hierdurch kann auf aufwendige Lacksysteme, die häufig umwelt- und gesundheitsschädliche Substanzen enthalten, verzichtet und zugleich eine sehr hohe UV-Beständigkeit erzielt werden. Insbesondere kann durch das Aufbringen von rostfreiem Edelstahl, Kupfer oder chrom-, nickel- und/oder kupferhaltigen Legierungen auf das mit mindestens einer metallischen Korrosionsschutzschicht versehene Kohlenstoffstahlblech Flachmaterial zur Verfügung gestellt werden, welches wie ein herkömmliches einschichtiges, rostfreies Edelstahlblech bzw. Kupferblech aussieht und für einen weiten Einsatzbereich, z.B. im Bauwesen, Fahrzeugbau, Schiffbau, in der Möbelindustrie, Hausgeräteindustrie und/oder Unterhaltungselektronik geeignet ist. Beispielsweise können aus dem erfindungsgemäßen oberflächenveredelten Stahlblech Verkleidungselemente für Gebäudefassaden, Geländer, Abdeckungen, Schalungselemente, Küchenmöbel, Gehäuse von Küchengeräten, Dunstabzugshaubengehäuse, Sanitärgeräte, Zierteile sowie Gehäuse und Einhausungen mit Designanspruch hergestellt werden. Beispielsweise kann auf einem verzinkten Kohlenstoffstahlblech durch das erfindungsgemäße Aufbringen einer Kupferlegierung eine Messing- oder Bronzeschicht erzeugt werden. Das erfindungsgemäße Stahlblech bietet dabei gegenüber einem entsprechenden Edelstahl- oder Kupferblech, d.h. einem einschichtigen Blech, welches aus rostfreiem Edelstahl bzw. Kupfer hergestellt ist, neben dem Kostenvorteil gegebenenfalls auch eine verbesserte mechanische Stabilität durch das als Träger fungierende Stahlblech. Zudem garantiert insbesondere die mindestens eine metallische Korrosionsschutzschicht für eine hohe Korrosionsbeständigkeit des erfindungsgemäßen Stahlblechs. Durch Zugabe von Zinn (Sn) bzw. Aufbringen einer Zinn enthaltenden Kupferlegierung lässt sich eine hochkorrosionsbeständige Bronze-Legierung als weitere metallische Schicht auf der metallischen Korrosionsschicht erzielen.

Die Dicke des aus Kohlenstoffstahl hergestellten Blechs liegt beispielsweise im Bereich von 0,05 bis 30 mm, vorzugsweise im Bereich von 0,5 bis 5 mm.

Die mindestens eine metallische Korrosionsschutzschicht des erfindungsgemäßen Stahlblechs ist eine auf Zink und/oder Aluminium basierende Korrosionsschutzschicht, z.B. eine Korrosionsschutzschicht vom Typ Z, ZE, ZA, AZ, FAL oder ZM. Die Korrosionsschutzschicht wird mittels eines Schmelztauchprozesses oder eines elektrolytischen Prozesses auf das aus Kohlenstoffstahl hergestellte Blech aufgebracht. Sie stellt zumindest den Korrosionsschutz einer der oder beider Flachseiten (Breitseiten) des Stahlblechs sicher. Vorzugsweise kann sich der Korrosionsschutz des erfindungsgemäßen Stahlblechs aber zudem auch auf die (Schnitt-)Kanten erstrecken, was sich insbesondere bei zinkbasierten Beschichtungen verwirklichen lässt.

Vorzugsweise wird die mindestens eine metallische Schicht durch chemische oder physikalische Gasphasenabscheidung auf die metallische Korrosionsschutzschicht aufgebracht. Die Abscheidung erfolgt dabei vorzugsweise im Vakuum, unter Inertgas (z.B. Argon) oder in einer reaktiven Atmosphäre (z.B. Sauerstoff oder Luft), wobei eine Metall-, Metalloxid-, Metallcarbid- und/oder Metallnitridschicht auf der metallischen Korrosionsschutzschicht abgeschieden wird. Die auf die Korrosionsschutzschicht aufgebrachte metallische Schicht kann auch mehrlagig ausgeführt sein. Vorzugsweise wird die mindestens eine metallische Schicht mit einer Dicke im Bereich von 1 nm bis 10 µm, besonders bevorzugt mit einer Dicke im Bereich von 50 bis 200 nm auf die metallische Korrosionsschutzschicht aufgebracht.

Die physikalische Abscheidung aus der Gasphase kann bei dem erfindungsgemäßen Verfahren unter Vakuumbedingungen und/oder unter Zugabe von Inertgas, vorzugsweise Argon, erfolgen. Die chemische Gasphasenabscheidung erfolgt dagegen unter reaktiver Atmosphäre, beispielsweise unter oxidativen Bedingungen durch Zugabe von Sauerstoff oder Luft. Auf diese Weise kann die Abscheidung einer oder mehrerer Metalloxidschichten auf der Korrosionsschutzschicht erfolgen. Dies kann vorteilhaft sein hinsichtlich der Korrosionsbeständigkeit der beschichteten Werkstoffe, insbesondere im Hinblick auf die elektrochemische Spannungsreihe der beteiligten Metalle und Verbindungen, insbesondere bei Anwesenheit von Zink und Edelstahl.

Die mindestens eine metallische Korrosionsschutzschicht vor dem Aufbringen der mindestens einen weiteren metallischen Schicht texturiert wird. Die Texturierung erfolgt im makroskopischen und/oder mikroskopischen Bereich, beispielsweise durch Einprägen von Mustern, Dressieren, Bürsten oder dergleichen. Nach der Texturierung wird dann die mindestens eine weitere metallische Schicht aufgebracht. Durch die Texturierung können die gewünschten optischen Effekte verbessert bzw. verstärkt werden. Beispielsweise können so bestimmte Muster oder der Eindruck eines gebürsteten Edelstahl- oder Kupferblechs erzeugt werden.

Eine weitere bevorzugte Ausgestaltung der Erfindung besteht darin, dass auf die mindestens eine weitere metallische Schicht mindestens eine transparente Schicht aufgebracht wird. Unter einer transparenten Schicht wird im vorliegenden Kontext auch eine semitransparente (halbtransparente) Schicht, insbesondere eine durchsichtige farbige Schicht verstanden, z.B. eine transparente Schicht, die bei einer Edelstahloptik einen leichten Blaustich oder einen leichten Rotstich als Designeffekt aufweist. Bei der transparenten Schicht kann es sich insbesondere auch um einen Klarlack oder eine sogenannte Anti-Fingerabdruck-Beschichtung handeln, die beispielsweise auf organischem Beschichtungsmaterial basiert. Durch diese optionale transparente (bzw. semitransparente) Schicht kann zudem der Korrosionsschutz des erfindungsgemäßen Stahlblechs weiter verbessert werden.

Nachfolgend werden Ausführungsbeispiele darstellenden Zeichnung näher erläutert. Es zeigen schematisch:
- Fig. 1: eine Anlage zur Durchführung des erfindungsgemäßen Verfahrens;
- Fig. 2: einen Abschnitt eines oberflächenveredelten Stahlblechs in Querschnittansicht; und
- Fig. 3: einen Abschnitt eines oberflächenveredelten Stahlblechs gemäß einem weiteren Ausführungsbeispiel der Erfindung, ebenfalls in Querschnittansicht.

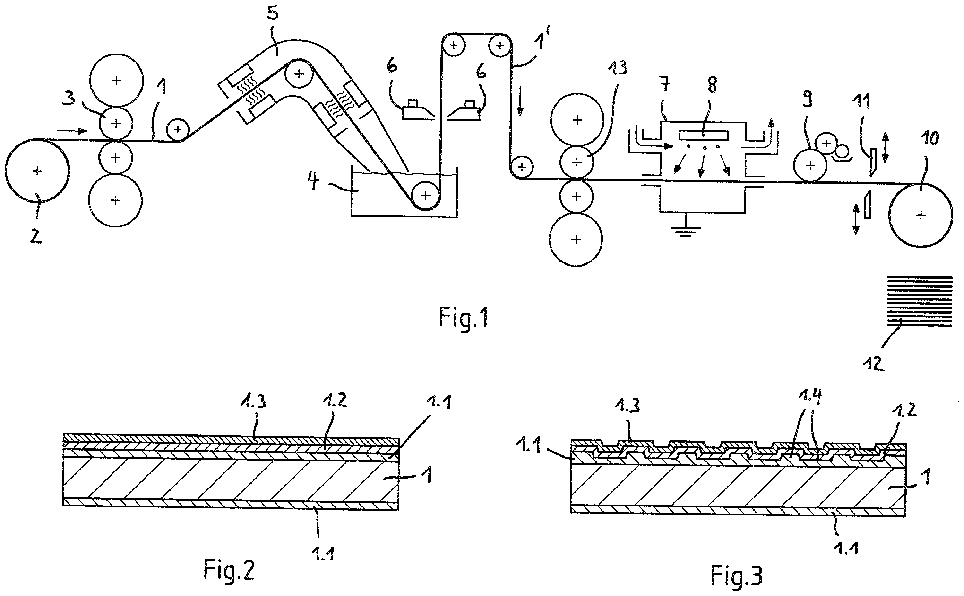

In Fig. 1 ist eine Anlage zur Oberflächenveredelung von Stahlblech aus Kohlenstoffstahl (C-Stahl) skizziert. Das erfindungsgemäß zu veredelnde Flachprodukt 1 aus C-Stahl weist beispielsweise folgende chemische Zusammensetzung auf:

| | |
|---|---|
| C | 0,12 - 0,65 Gew.-%, |
| Si | max. 0,40 Gew.-%, |
| Mn | 0,30 - 0,90 Gew.-%, |
| P | max. 0,025 Gew.%, |
| S | max. 0,010 Gew.%, |
| Cr | max. 0,40 Gew.%, |
| Mo | max. 0,10 Gew.%, und |
| Ni | max. 0,40 Gew.%. |

Der Kohlenstoffstahl wird der Anlage vorzugsweise als Coil 2 zugeführt. Die Dicke des bandförmigen C-Stahls 1 liegt dabei beispielsweise im Bereich von 0,05 mm bis 30 mm. Das bandförmige C-Stahlblech 1 erfährt nach dem Warm- und/oder Kaltwalzen 3 eine erste Oberflächenveredelung, die dem Korrosionsschutz der Breitflächen und, je nach Beschichtungssystem, auch den Kanten des Stahlbandes 1 dient. Bei dieser Oberflächenveredelung bzw. Verzinkung kann es sich beispielsweise um eine Feuerverzinkung (Z), eine elektrolytische Verzinkung (ZE), eine Zink-Aluminium-Beschichtung (ZA), eine Aluminium- Zink-Beschichtung (AZ), eine Feuer-Aluminium-Beschichtung (FAL) oder Zink-Magnesium-Beschichtung (ZM) handeln.

Das Stahlband 1 wird vorzugsweise in einem Schmelztauchbad 4 beidseitig verzinkt bzw. korrosionsschutzbeschichtet. Zuvor wird das Stahlband 1 in einem Durchlaufofen 4 erhitzt. Mit 6 sind Abstreifvorrichtungen, beispielsweise Blasdüsen, bezeichnet, mittels denen überschüssiges Korrosionsschutzmaterial bzw. Verzinkungsmaterial von dem Stahlband 1 abgetrennt und die gewünschte Dicke der metallischen Korrosionsschutzschicht eingestellt wird.

Anschließend wird durch einen zweiten Oberflächenveredelungsprozess auf mindestens eine Seite des mit der metallischen Korrosionsschutzschicht versehenden Stahlbandes 1' mindestens eine weitere metallische Schicht aufgebracht, wobei diese metallische Schicht auf rostfreiem Edelstahl, Kupfer, einer chrom- oder nickelhaltigen Legierung und/oder einer Kupferlegierung basiert. Die mindestens eine weitere metallische Schicht wird vorzugsweise durch physikalische Gasphasenabscheidung (PVD) oder chemische Gasphasenabscheidung (CVD) auf das korrosionsschutzbeschichtete Stahlband aufgebracht. Die Schichtdicke liegt im Bereich von 1 nm bis 10 µm, vorzugsweise im Bereich von 50 bis 200 nm. Die zusätzliche metallische Schicht kann dabei auch mehrlagig auf die Korrosionsschutzschicht aufgebracht werden. Die Vorrichtung zum Aufbringen der relativ dünnen weiteren metallischen Schicht bzw. zur Durchführung der Gasphasenabscheidung ist in Fig. 1 mit dem Bezugszeichen 7 bezeichnet.

Die Gasphasenabscheidung der dünnen weiteren metallischen Schicht erfolgt vorzugsweise unter Vakuumbedingungen oder unter Zugabe von Inertgas, vorzugsweise Argon. Das auf die Korrosionsschutzschicht aufzubringende Metall wird dabei in einen gasförmigen Zustand überführt und auf der Korrosionsschutzschicht kondensiert. Zur Überführung des Metalls in den gasförmigen Zustand wird dieses beispielsweise erhitzt, bis es mit einer geeigneten Aufdampfrate verdampft. Um eine hochwertige und möglicht homogene Metallschicht auf der Korrosionsschutzschicht aufzubringen ist es günstig, wenn der Raum zwischen dem Verdampfer und dem zu beschichteten Substrat 1' möglichst materialfrei ist, weshalb die Abscheidung vorzugsweise unter Vakuumbedingungen erfolgt. Ergänzend oder alternativ zur Verwendung eines thermisch wirkenden Verdampfers kann das auf die Korrosionsschutzschicht aufzubringende Metall auch durch lonenbeschuss in die Gasphase überführt werden. Bei diesem physikalischen Beschichtungsprozess (auch Sputterdeposition genannt) werden durch lonenbeschuss Teilchen an der Oberfläche eines das aufzutragende Metall bereitstellenden Körpers 8, dem sogenannten Target, zerstäubt und dadurch von der Oberfläche des Körpers abgetragen. Das so entstandene gasförmige Metall wird anschließend auf das zu beschichtende, bereits korrosionsschutzbeschichtete Stahlblech 1' geführt und kondensiert dort.

Alternativ zu der Betriebsweise unter Vakuum kann die Gasphasenabscheidung von Metalloxidschichten auch unter reaktiver Atmosphäre, insbesondere unter oxidativen Bedingungen durch Zugabe von Sauerstoff oder Luft durchgeführt werden. Dadurch kann ein Vorteil hinsichtlich der Korrosionsbeständigkeit des beschichteten C-Stahls insbesondere im Hinblick auf die elektrochemische Spannungsreihe der beteiligten Metalle und Verbindungen, insbesondere bei Anwesenheit von Zink und Edelstahl, erreicht werden.

Auf eine der vorgenannten Weisen wird das korrosionsschutzbeschichtete Stahlblech 1' erfindungsgemäß mit mindestens einer zusätzlichen Metall-, Metalloxid-, Metallcarbid- und/oder Metallnitridschicht versehen, die dem Stahlblech 1' ein hochwertiges, beispielsweise ein edelstahlähnliches Aussehen verleiht.

Als zusätzlicher Korrosionsschutz kann anschließend noch mindestens eine transparente Schicht aufgetragen werden. Diese transparente Schicht wird vorzugsweise aus einem organischen Beschichtungsmaterial, beispielsweise einem Klarlack gebildet. Die transparente Schicht kann neben der zusätzlichen Korrosionsschutzfunktion auch eine Anti-Fingerabdruck-Funktion erfüllen. Das Auftragen der mindestens einen transparenten Schicht erfolgt beispielsweise mittels Farbauftragsrollen 9 oder Sprühdüsen. Zudem kann die transparente Schicht auch leicht farbig getönt sein, beispielsweise einen leichten Blau-, Rot-, Grün- oder Gelbstich aufweisen, so dass sie gegebenenfalls auch eine Designfunktion hat.

Nach dem Erzeugen bzw. Abscheiden der mindestens einen weiteren metallischen Schicht und dem optionalen Aufbringen der mindestens einen transparenten Schicht wird das oberflächenveredelte Stahlband zu einem Coil 10 aufgewickelt oder mittels einer Schneidvorrichtung 11 in eine Vielzahl von Platinen 12 bestimmter Länge abgelängt. Nach der Erfindung wird auf die metallische Korrosionsschutzschicht des Flachproduktes aus C-Stahl eine weitere metallische Schicht aus rostfreiem Edelstahl aufgebracht. Dies kann beispielsweise durch physikalische Gasphasenabscheidung unter Verwendung von geeignetem Edelstahl (z.B. vom Legierungstyp 1.4301) als Target 8 erfolgen. Alternativ oder ergänzend können für die mindestens eine weitere metallische Schicht auch chrom- und/oder nickelhaltige Legierungen, sogenannte Nickelbasislegierungen, wie zum Beispiel Nickel-Kupfer-, Nickel-Eisen-, Nickel-Eisen-Chrom-, Nickel-Chrom-, Nickel-Molybdän, Nickel-Chrom-Kobalt- und/oder niedriglegierte Nickellegierungen als Targets 8 bei der physikalischen Gasphasenabscheidung verwendet werden. Mit einem solchen Target 8 wird dem korrosionsschutzbeschichteten Stahlblech 1' aus C-Stahl das Aussehen eines rostfreien Edelstahlblechs bzw. ein edelstahlähnliches Aussehen verliehen.

In einer anderen bevorzugten Ausführungsform der Erfindung wird auf die metallische Korrosionsschutzschicht des C-Stahlsubstrats 1' eine weitere metallische Schicht aus Kupfer oder einer Kupferlegierung mittels Gasphasenabscheidung aufgebracht. Durch die Verwendung von Kupfer bzw. Kupferlegierungen werden dekorative Kupfer-, Messing- oder Bronzeschichten erzeugt. Durch Verwendung einer Zinn (Sn) enthaltenden Kupferlegierung kann eine hochkorrosionsbeständige Bronze-Legierung auf der Oberfläche der metallischen Korrosionsschutzschicht des C-Stahlsubstrats 1' abgeschieden werden.

Nach dem Aufbringen der Korrosionsschutzschicht erfolgt eine Texturierung der Oberfläche des beschichteten Stahlblechs 1' im makroskopischen und/oder mikroskopischen Bereich in Form von Einprägungen, Mustern usw. Hierzu wird beispielsweise mindestens eine Dressierwalze 13 und/oder Bürstenvorrichtung verwendet. Durch die Texturierung kann die erzeugte optische Wirkung des erfindungsgemäßen Stahlblechs verbessert, beispielsweise der optische Effekt eines gebürsteten Edelstahlblechs besonders wirklichkeitsnah nachgeahmt werden.

In Fig. 2 ist ein Abschnitt eines nicht erfinderischen Stahlblechs dargestellt, das eine Trägerschicht 1 aus C-Stahl aufweist, die beidseitig mit einer metallischen Korrosionsschutzschicht 1.1 versehen ist. Die Dicke der Trägerschicht 1 liegt beispielsweise im Bereich von 0,05 bis 30 mm, insbesondere im Bereich von 0,1 bis 3 mm. Bei der Korrosionsschutzschicht 1.1 handelt es sich um eine auf Zink und/oder Aluminium basierenden Metallschicht. Auf mindestens eine der Korrosionsschutzschichten 1.1 ist eine weitere metallische Schicht 1.2 stoffschlüssig aufgebracht. Die metallische Schicht 1.2 basiert auf rostfreiem Edelstahl, Kupfer, einer chrom- und/oder nickelhaltigen Legierung und/oder einer Kupferlegierung. Die metallische Schicht 1.2 ist relativ dünn; ihre Dicke liegt im Bereich von ca. 1 nm bis 10 µm, vorzugsweise im Bereich von 50 bis 200 nm. Optional ist die metallische Schicht 1.2 mit einer transparenten, organischen Schicht 1.3, z.B. einem Klarlack, einer leicht eingefärbten, durchsichtigen Schicht oder einer Anti-Fingerabdruckbeschichtung versehen.

Das in Fig. 3 dargestellte Ausführungsbeispiel des erfindungsgemäßen Stahlblechs unterscheidet sich von dem in Fig. 2 gezeigten Ausführungsbeispiel dadurch, dass die Korrosionsschutzschicht 1.1 vor dem Aufbringen der weiteren metallischen Schicht 1.2 und der optionalen transparenten Schicht 1.3 mit einer Oberflächentextur in Form von Einprägungen bzw. kleinen Erhebungen 1.4 versehen wurde. Die Oberflächentextur zeichnet sich auch in der metallischen Schicht 1.2 sowie der optionalen transparenten Schicht 1.3 ab.

Die transparente Schicht 1.3 kann jedoch als Klarlack oder semitransparenter Farblack auch in der Weise auf die strukturierte metallische Schicht 1.2 aufgetragen werden, dass sie schließlich eine im Wesentlichen ebene bzw. glatte Oberfläche besitzt. Die Struktur ist dann im Wesentlichen nur innerhalb der Beschichtung ausgebildet. In diesem Fall weist das fertige oberflächenveredelte Stahlblech also an seiner die Texturierung aufweisenden Seite eine im Wesentlichen ebene bzw. glatte Oberfläche auf, was hinsichtlich der Vermeidung von Schmutzanlagerungen an dem Stahlblech von Vorteil ist.

## Patentansprüche

1. Oberflächenveredeltes Stahlblech aus Kohlenstoffstahl mit einer Beschichtung, die aus mindestens einer metallischen Korrosionsschutzschicht (1.1) und mindestens einer weiteren, auf die metallische Korrosionsschutzschicht stoffschlüssig aufgebrachten Schicht (1.2) aufgebaut ist, **dadurch gekennzeichnet, dass** die mindestens eine weitere Schicht (1.2) eine metallische Schicht ist oder aus einer metallischen Schicht gebildet ist, wobei die metallische Schicht (1.2) auf rostfreiem Edelstahl, einer chrom- und/oder nickelhaltigen Legierung, Kupfer und/oder einer Kupferlegierung basiert, wobei die mindestens eine metallische Korrosionsschutzschicht (1.1) eine auf Zink und/oder Aluminium basierende Korrosionsschutzschicht ist und texturiert ist.

2. Oberflächenveredeltes Stahlblech nach Anspruch 1, **dadurch gekennzeichnet, dass** die mindestens eine weitere metallische Schicht (1.2) durch chemische oder physikalische Gasphasenabscheidung auf die metallische Korrosionsschutzschicht aufgebracht ist.

3. Oberflächenveredeltes Stahlblech nach Anspruch 1 oder 2, **dadurch gekennzeichnet, dass** die mindestens eine weitere metallische Schicht (1.2) eine Dicke im Bereich von 1 nm bis 10 µm, vorzugsweise 50 bis 200 nm aufweist.

4. Oberflächenveredeltes Stahlblech nach einem der Ansprüche 1 bis 3, **dadurch gekennzeichnet, dass** auf die mindestens eine weitere metallische Schicht (1.2) mindestens eine transparente Schicht (1.3) aufgebracht ist.

5. Oberflächenveredeltes Stahlblech nach einem der Ansprüche 1 bis 4, **dadurch gekennzeichnet, dass** die mindestens eine metallische Korrosionsschutzschicht (1.1) eine Korrosionsschutzschicht vom Typ Feuerverzinkung (Z), eine elektrolytische Verzinkung (ZE), eine Zink-Aluminium-Beschichtung (ZA), eine Aluminium- Zink-Beschichtung (AZ), eine Feuer-Aluminium-Beschichtung (FAL) oder Zink-Magnesium-Beschichtung (ZM) ist.

6. Oberflächenveredeltes Stahlblech nach einem der Ansprüche 1 bis 5, **dadurch gekennzeichnet, dass** die mindestens eine metallische Korrosionsschutzschicht (1.1) mittels eines Schmelztauchprozesses oder eines elektrolytischen Prozesses auf das Stahlblech aus Kohlenstoffstahl aufgebracht ist.

7. Verfahren zum Herstellen eines oberflächenveredelten Stahlblechs, bei dem auf ein Flachprodukt (1) aus Kohlenstoffstahl mindestens eine metallische Korrosionsschutzschicht (1.1) und auf die mindestens eine metallische Korrosionsschutzschicht mindestens eine weitere Schicht (1.2) stoffschlüssig aufgebracht werden, **dadurch gekennzeichnet, dass** auf die mindestens eine metallische Korrosionsschutzschicht (1.1) mindestens eine metallische Schicht als weitere Schicht (1.2) stoffschlüssig aufgebracht wird, wobei die metallische Schicht (1.2) auf rostfreiem Edelstahl, einer chrom- und/oder nickelhaltigen Legierung, Kupfer und/oder einer Kupferlegierung basiert und die mindestens eine metallische Korrosionsschutzschicht (1.1) eine auf Zink und/oder Aluminium basierende Korrosionsschutzschicht ist und texturiert wird.

8. Verfahren nach Anspruch 7, **dadurch gekennzeichnet, dass** die mindestens eine metallische Schicht (1.2) durch chemische oder physikalische Gasphasenabscheidung auf die metallische Korrosionsschutzschicht (1.1) aufgebracht wird.

9. Verfahren nach Anspruch 7 oder 8, **dadurch gekennzeichnet, dass** die mindestens eine metallische Schicht (1.2) mit einer Dicke im Bereich von 1 nm bis 10 µm, vorzugsweise 50 bis 200 nm auf die metallische Korrosionsschutzschicht (1.1) aufgebracht wird.

10. Verfahren nach einem der Ansprüche 7 bis 9, **dadurch gekennzeichnet, dass** auf die mindestens eine weitere metallische Schicht (1.2) mindestens eine transparente Schicht (1.3) aufgebracht wird.

11. Verfahren nach einem der Ansprüche 7 bis 10, **dadurch gekennzeichnet, dass** die mindestens eine metallische Korrosionsschutzschicht (1.1) eine Korrosionsschutzschicht vom Typ Feuerverzinkung (Z), eine elektrolytische Verzinkung (ZE), eine Zink-Aluminium-Beschichtung (ZA), eine Aluminium- Zink-Beschichtung (AZ), eine Feuer-Aluminium-Beschichtung (FAL) oder Zink-Magnesium-Beschichtung (ZM) ist.

12. Verfahren nach einem der Ansprüche 7 bis 11, **dadurch gekennzeichnet, dass** die Korrosionsschutzschicht mittels eines Schmelztauchprozesses oder eines elektrolytischen Prozesses auf das Flachprodukt aus Kohlenstoffstahl aufgebracht wird.

## Claims

1. Surface-upgraded steel sheet composed of carbon steel and having a coating which is made up of at least one metallic anticorrosion layer (1.1) and at least one further layer (1.2) which is applied and material bonded to the metallic anticorrosion layer, **characterized in that** the at least one further layer (1.2) is a metallic layer or is formed from a metallic layer, where the metallic layer (1.2) is based on stainless steel, a chromium- and/or nickel-containing alloy, copper and/or a copper alloy, where the at least one metallic anticorrosion layer (1.1) is an anticorrosion layer based on zinc and/or aluminium and is textured.

2. Surface-upgraded steel sheet according to Claim 1, **characterized in that** the at least one further metallic layer (1.2) has been applied by chemical or physical vapour deposition to the metallic anticorrosion layer.

3. Surface-upgraded steel sheet according to Claim 1 or 2, **characterized in that** the at least one further metallic layer (1.2) has a thickness in the range from 1 nm to 10 µm), preferably from 50 to 200 nm.

4. Surface-upgraded steel sheet according to any of Claims 1 to 3, **characterized in that** at least one transparent layer (1.3) has been applied on top of the at least one further metallic layer (1.2).

5. Surface-upgraded steel sheet according to any of Claims 1 to 4, **characterized in that** the at least one metallic anticorrosion layer (1.1) is an anticorrosion layer of the hot galvanizing (Z) type, an electrolytic galvanizing (ZE), a zinc-aluminium coating (ZA), an aluminium-zinc coating (AZ), a hot aluminium coating (FAL) or zinc-magnesium coating (ZM).

6. Surface-upgraded steel sheet according to any of Claims 1 to 5, **characterized in that** the at least one metallic anticorrosion layer (1.1) has been applied by means of a melt dipping process or an electrolytic process to the steel sheet composed of carbon steel.

7. Process for producing a surface-upgraded steel sheet, in which at least one metallic anticorrosion layer (1.1) is applied to a sheet product (1) composed of carbon steel and at least one further layer (1.2) is applied and material bonded to the at least one metallic anticorrosion layer, **characterized in that** at least one metallic layer is applied and material bonded as further layer (1.2) to the at least one metallic corrosion protection layer (1.1), where the metallic layer (1.2) is based on stainless steel, a chromium- and/or nickel-containing alloy, copper and/or a copper alloy and the at least one metallic anticorrosion layer (1.1) is an anticorrosion layer based on zinc and/or aluminium and is textured.

8. Process according to Claim 7, **characterized in that** the at least one metallic layer (1.2) is applied by chemical or physical vapour deposition to the metallic anticorrosion layer (1.1).

9. Process according to Claim 7 or 8, **characterized in that** the at least one metallic layer (1.2) is applied in a thickness in the range from 1 nm to 10 µm), preferably from 50 to 200 nm, to the metallic anticorrosion layer (1.1).

10. Process according to any of Claims 7 to 9, **characterized in that** at least one transparent layer (1.3) is applied on top of the at least one further metallic layer (1.2).

11. Process according to any of Claims 7 to 10, **characterized in that** the at least one metallic anticorrosion layer (1.1) is an anticorrosion layer of the hot galvanizing (Z) type, an electrolytic galvanizing (ZE), a zinc-aluminium coating (ZA), an aluminium-zinc coating (AZ), a hot aluminium coating (FAL) or zinc-magnesium coating (ZM).

12. Process according to any of Claims 7 to 11, **characterized in that** the anticorrosion layer is applied by means of a melt dipping process or an electrolytic process to the sheet product composed of carbon steel.

## Revendications

1. Tôle d'acier traitée en surface en acier au carbone, avec un revêtement composé d'au moins une couche de protection anticorrosion métallique (1.1) et d'au moins une couche supplémentaire (1.2) appliquée par liaison de matière sur la couche de protection anticorrosion métallique, **caractérisée en ce que** ladite au moins une couche supplémentaire (1.2) est une couche métallique ou est formée d'une couche métallique, la couche métallique (1.2) étant à base d'acier spécial inoxydable, d'un alliage contenant du chrome et/ou du nickel, de cuivre et/ou d'un alliage de cuivre, dans laquelle ladite au moins une couche de protection anticorrosion métallique (1.1) est une couche de protection anticorrosion à base de zinc et/ou d'aluminium et est texturée.

2. Tôle d'acier traitée en surface selon la revendication 1, **caractérisée en ce que** ladite au moins une couche supplémentaire métallique (1.2) est appliquée sur la couche de protection anticorrosion métallique par dépôt chimique ou physique en phase vapeur.

3. Tôle d'acier traitée en surface selon la revendication 1 ou 2, **caractérisée en ce que** ladite au moins une couche supplémentaire métallique (1.2) présente une épaisseur dans la plage de 1 nm à 10 µm, de préférence de 50 à 200 nm.

4. Tôle d'acier traitée en surface selon l'une quelconque des revendications 1 à 3, **caractérisée en ce qu'**au moins une couche transparente (1.3) est appliquée sur ladite au moins une couche supplémentaire métallique (1.2).

5. Tôle d'acier traitée en surface selon l'une quelconque des revendications 1 à 4, **caractérisée en ce que** ladite au moins une couche de protection anticorrosion métallique (1.1) est une couche de protection anticorrosion de type galvanisation à chaud (Z), une galvanisation électrolytique (ZE), un revêtement en zinc-aluminium (ZA), un revêtement en aluminium-zinc (AZ), un revêtement à aluminage à chaud (FAL) ou un revêtement en zinc-magnésium (ZM).

6. Tôle d'acier traitée en surface selon l'une quelconque des revendications 1 à 5, **caractérisée en ce que** ladite au moins une couche de protection anticorrosion métallique (1.1) est appliquée sur la tôle d'acier en acier au carbone au moyen d'un processus de galvanisation à chaud ou d'un processus électrolytique.

7. Procédé de fabrication d'une tôle d'acier traitée en surface, dans lequel au moins une couche de protection anticorrosion métallique (1.1) est appliquée par liaison de matière sur un produit laminé plat (1) en acier au carbone, et au moins une couche supplémentaire (1.2) est appliquée par liaison de matière sur ladite au moins une couche de protection anticorrosion métallique, **caractérisé en ce qu'**au moins une couche métallique est appliquée par liaison de matière comme couche supplémentaire (1.2) sur ladite au moins une couche de protection anticorrosion métallique (1.1), dans lequel la couche métallique (1.2) est à base d'acier spécial inoxydable, d'un alliage contenant du chrome et/ou du nickel, de cuivre et/ou d'un alliage de cuivre, et ladite au moins une couche de protection anticorrosion métallique (1.1) est une couche de protection anticorrosion à base de zinc et/ou d'aluminium et est texturée.

8. Procédé selon la revendication 7, **caractérisé en ce que** ladite au moins une couche métallique (1.2) est appliquée par dépôt chimique ou physique en phase vapeur sur la couche de protection anticorrosion métallique (1.1).

9. Procédé selon la revendication 7 ou 8, **caractérisé en ce que** ladite au moins une couche métallique (1.2) d'une épaisseur dans la plage de 1 nm à 10 µm, de préférence de 50 à 200 nm, est appliquée sur la couche de protection anticorrosion métallique (1.1).

10. Procédé selon l'une quelconque des revendications 7 à 9, **caractérisé en ce qu'**au moins une couche transparente (1.3) est appliquée sur ladite au moins une couche supplémentaire métallique (1.2).

11. Procédé selon l'une quelconque des revendications 7 à 10, **caractérisé en ce que** ladite au moins une couche de protection anticorrosion métallique (1.1) est une couche de protection anticorrosion de type galvanisation à chaud (Z), une galvanisation électrolytique (ZE), un revêtement en zinc-aluminium (ZA), un revêtement en aluminium-zinc (AZ), un revêtement à aluminage à chaud (FAL) ou un revêtement en zinc-magnésium (ZM).

12. Procédé selon l'une quelconque des revendications 7 à 11, **caractérisé en ce que** la couche de protection anticorrosion est appliquée sur le produit laminé plat en acier au carbone au moyen d'un processus de galvanisation à chaud ou d'un processus électrolytique.
